# EUROPEAN PATENT APPLICATION

(11) **EP 4 776 786 A1**
(43) Date of publication of application: **15.07.2026**
(21) Application number: 25188303.9
(22) Date of filing: 09.07.2025
(51) Int. Cl.: H10D 30/01, H10D 30/47, H10D 62/17, H10D 64/00, H10D 62/85

(54) **HIGH-ELECTRON-MOBILITY TRANSISTORS WITH FIELD PLATE**

(30) Priority: 08.01.2025 US 202519013322
(71) Applicant: GlobalFoundries U.S. Inc., Malta, NY 12020 (US)
(72) Inventor: Levy, Mark David, Essex Junction 05452 (US); Ellis-Monaghan, John Joseph, Essex Junction 05452 (US); Zierak, Michael Joseph, Essex Junction 05452 (US); Susai, Lawrence Selvaraj, Essex Junction 05452 (US)
(74) Representative: Grünecker Patent- und Rechtsanwälte PartG mbB

(57) **Abstract**

The present disclosure relates to semiconductor structures and, more particularly, to high-electron-mobility transistors with field plates and methods of manufacture. The structure includes: a gate structure on a semiconductor substrate; a passivation layer adjacent to the gate structure and above the semiconductor substrate; an insulator material over the passivation layer; and a field plate comprising a first portion contacting the passivation layer and a second portion being separated from the passivation layer by the insulator material.

## Description

### BACKGROUND

This invention was made with government support under contract number HQ0727790700 awarded by Defense Microelectronics Activity (DMEA). The government has certain rights in the invention.

The present disclosure relates to semiconductor structures and, more particularly, to high-electron-mobility transistors with field plates and methods of manufacture.

A high-electron-mobility transistor (HEMT) is a field-effect transistor incorporating a junction between two materials with different band gaps (i.e. a heterojunction) as the channel. HEMT transistors are able to operate at higher frequencies than ordinary transistors, e.g., up to millimeter wave frequencies, and are used in high-frequency products such as cell phones, satellite television receivers, voltage converters, microwave and millimeter wave communications, radio astronomy, power switching and radar equipment. The HEMTs can also be used in satellite receivers in low power amplifiers.

### SUMMARY

In an aspect of the disclosure, a structure comprises: a gate structure on a semiconductor substrate; a passivation layer adjacent to the gate structure and above the semiconductor substrate; an insulator material over the passivation layer; and a field plate comprising a first portion contacting the passivation layer and a second portion being separated from the passivation layer by the insulator material.

In an aspect of the disclosure, a gate structure; a source region comprising a first ohmic contact adjacent to a first side of the gate structure; a drain region comprising a second ohmic contact adjacent to a second side of the gate structure; a passivation layer between the gate structure and the drain region; a field plate comprises a first portion contacting a first portion of the passivation layer and a second portion separated from a second portion the passivation layer; and an insulator material between the second portion of the field plate and the second portion of the passivation layer.

In an aspect of the disclosure, a method comprises: forming a gate structure on a semiconductor substrate; forming a passivation layer adjacent to the gate structure and above the semiconductor substrate; forming an insulator material over the passivation layer; and forming a field plate comprising a first portion contacting the passivation layer and a second portion being separated from the passivation layer by the insulator material.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a structure and respective fabrication processes in accordance with aspects of the present disclosure.
FIG. 2 shows a structure and respective fabrication processes in accordance with additional aspects of the present disclosure.
FIGS. 3A-3D show fabrication processes to manufacture the structure shown in FIG. 1 in accordance with aspects of the present disclosure.

### DETAILED DESCRIPTION

The present disclosure relates to semiconductor structures and, more particularly, to high-electron-mobility transistors with field plates and methods of manufacture. More specifically, the high-electron-mobility transistor (HEMT) may be an eMode HEMT with a field plate close to a surface of a top layer of an AlGaN stack of semiconductor layers, e.g., close to a surface of a top AlGaN semiconductor layer. In embodiments, a portion of the field plate may be above, coincident with (e.g., planar with) or below a portion of a dielectric material (e.g., AlxOy) that is near the surface of the top semiconductor layer. Advantageously, the location of the field plate provides improved off-state leakage, eliminates a leakage pathway and, by having the field plate at different locations, it is possible to tune a pinch off voltage of a dMode without affecting other processes.

The structures of the present disclosure can be manufactured in a number of ways using a number of different tools. In general, though, the methodologies and tools are used to form structures with dimensions in the micrometer and nanometer scale. The methodologies, i.e., technologies, employed to manufacture the structures of the present disclosure have been adopted from integrated circuit (IC) technology. For example, the structures are built on wafers and are realized in films of material patterned by photolithographic processes on the top of a wafer. In particular, the fabrication of the structures uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

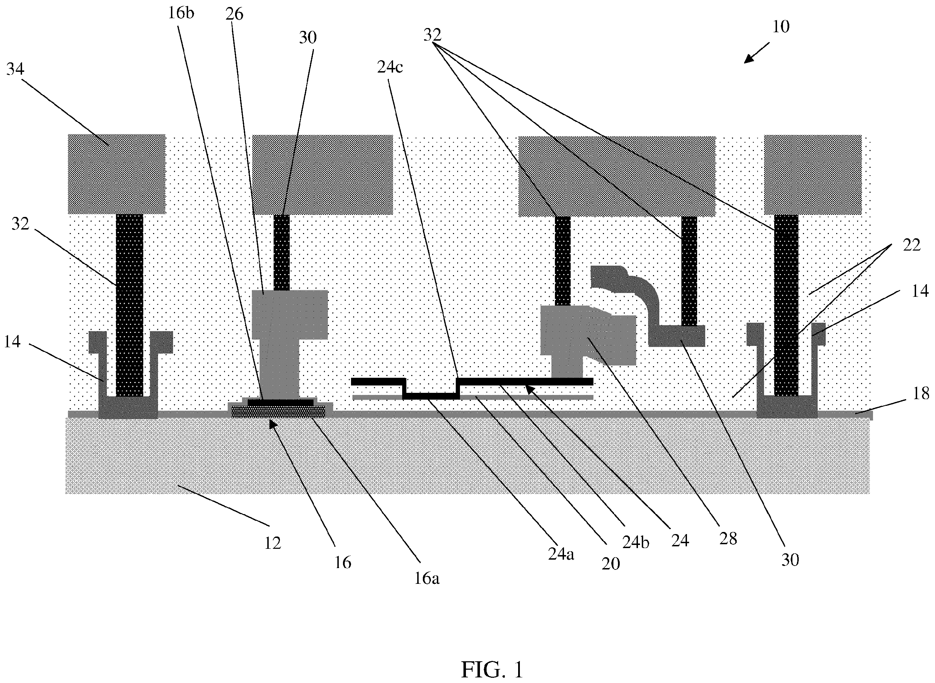

FIG. 1 shows a structure and respective fabrication processes in accordance with aspects of the present disclosure. The structure 10 includes a semiconductor substrate 12. The semiconductor substrate 12 may be, for example, a GaN stack of semiconductor materials and, more preferably, an AlGaN stack of semiconductor materials as is known in the art.

By way of an illustrative, non-limiting example, the AlGaN stack of semiconductor materials may include a nucleation layer, e.g., AiN, formed on an Si semiconductor substrate with one or more buffer layers between the AiN layer and GaN semiconductor material. As should be understood by those of skill in the art, the nucleation layer helps avoid melt-back etching of Ga into Si, as well as reduces the interlayer diffusion of impurities into the channel layer. The Si semiconductor may preferably be single crystalline Si material with a (111) orientation; although other crystalline orientations are contemplated herein (e.g., a (100), (110), or (001) crystallographic orientations). The buffer layers may be step graded, interlayer and superlattice layer(s) comprising one or more layers of AlGaN, with the composition of Al gradually decreasing from a bottom layer to a top layer. A GaN layer may be formed on an uppermost layer of AlGaN material. The GaN layer may act as a channel layer, with a 2D Electron Gas (2DEG) transition below the AlGaN material. The different semiconductor layers may be formed by an epitaxial growth process as is known in the art.

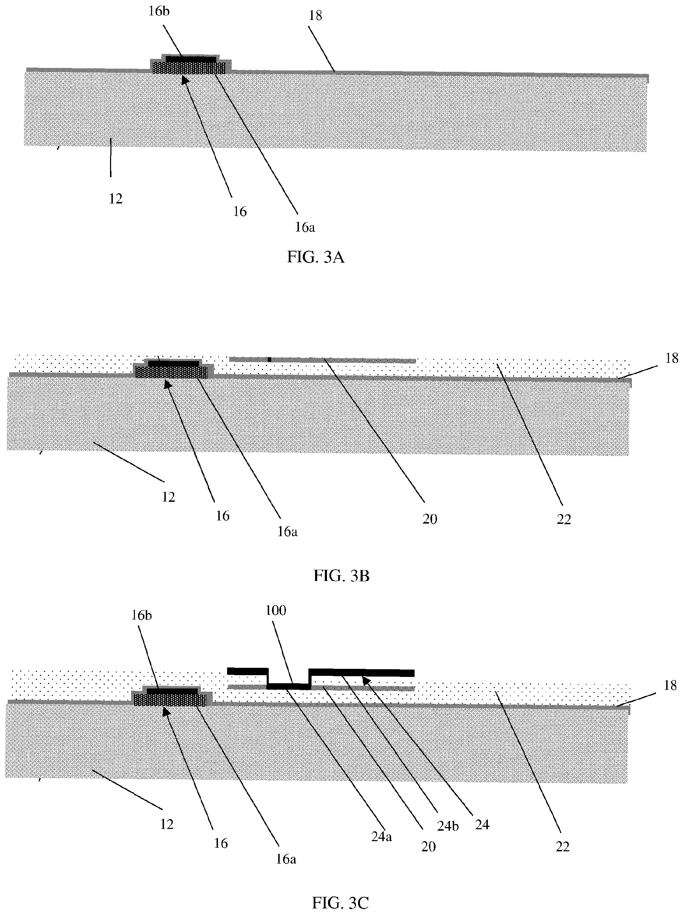

FIG. 1 further shows a gate structure 16 on the semiconductor substrate 12. The gate structure 16, for example, may comprise a doped GaN material 16a. In more specific embodiments, the gate structure 16 comprises a p-doped GaN (pGaN) material 16a formed by conventional epitaxial growth processes with an in-situ doping as is known in the art. The p-dopant may be, for example, Magnesium (Mg). The gate structure 16 may also include a layer of conductive material 16b, e.g., TiN material, formed over the doped GaN material 16a. The conductive material 16b may be, for example, titanium nitride formed by conventional processes as described with respect to FIG. 3A.

A passivation layer 18 may be formed over the gate structure 16 and semiconductor substrate 12. In embodiments, the passivation layer 18 may be, for example, AlxOy, deposited over the semiconductor substrate 12 after formation of the gate structure 16. The passivation layer 18 may be deposited by a conventional blanket deposition process as described with respect to FIG. 3A.

FIG. 1 further shows source and drain regions formed on sides of the gate structure 16. In embodiments, the source and drain regions may be ohmic contacts 14 formed on the semiconductor substrate 12. In embodiments, current flows between the source and drain regions, e.g., ohmic contacts 14, with the gate structure 16 controlling the current flow between the source and drain regions, e.g., ohmic contacts 14. The ohmic contacts 14 may be arranged as interdigitated fingers or other patterns, with the gate structure 16 arranged therebetween. The ohmic contacts 14 may be any conductive material such as, for example, aluminum, copper, gold, etc.

To form the ohmic contacts 14, a specific metallization scheme is deposited on the semiconductor substrate 12 to create low-resistance connections to the 2DEG (twodimensional electron gas) channel, essentially allowing electrons to flow freely between the source and drain terminals, e.g., ohmic contacts 14, while the gate structure 16 controls the current flow through the channel region. This may be achieved through a combination of material selection, patterning, and annealing steps as is known in the art, ensuring electrical contact while maintaining a Schottky barrier at the gate region to control the current flow.

By way of more specific example, the ohmic contacts 14 can be formed by conventional lithography, etching and deposition methods known to those of skill in the art. For example, the formation of the ohmic contacts 14 may include a resist formed over an interlevel dielectric material 22 (e.g., silicon dioxide) over the passivation layer 18, which is exposed to energy (light) and developed utilizing a conventional resist developer to form a pattern (opening). An etching process with a selective chemistry, e.g., reactive ion etching (RIE), may be used to transfer the pattern from the photoresist to the interlevel dielectric material 22 and the passivation layer 18 to form one or more openings exposing the underlying semiconductor substrate 12. Following the resist removal by a conventional oxygen ashing process or other known stripants, conductive material can be deposited by any conventional deposition processes, e.g., chemical vapor deposition (CVD) processes. The conductive material may be a metal stack (e.g., Ti, Al, Ni, or Au).

The metal stack may be annealed at a controlled temperature to alloy with the semiconductor substrate 12, forming low-resistance ohmic contacts 14. The annealing temperature and time is optimized to ensure good ohmic contact formation without damaging the device structure. Any residual material on the surface of the interlevel dielectric material can be removed or further patterned by conventional CMOS processes, e.g., chemical mechanical polishing (CMP) or etching processes (RIE).

FIG. 1 further shows a passivation layer 20 formed within the interlevel dielectric material 22. In embodiments, the passivation layer 20 may be an etch stop layer (ESL) that protects the underlying semiconductor substrate 12 from damage during the etching process. In further embodiments, the passivation layer 20 may be formed by a conventional deposition process, e.g., CVD, followed by a conventional patterning process, e.g., photolithography and etching processes. The passivation layer 20 may be aluminum oxide compounds or silicon nitride as examples.

As further shown in FIG. 1, the passivation layer 20 may be between the gate structure 16 and the ohmic contact 14 on the drain side of the structure. The passivation layer 20 may also be separated from the passivation layer 18, ohmic contact 14 and the gate structure 16 by the interlevel dielectric material 22. In further embodiments, the passivation layer 20 may be planar.

A field plate 24 may be formed partially coincident with the passivation layer 20. In this and other configurations, the field plate 24 may be a metal material in direct contact with a portion of the passivation layer 20 (e.g., AlxOy, where x and y are number values such as Al₂O₃). The metal material may be tantalum nitride deposited by a conventional deposition process, e.g., CVD, and patterned using conventional lithography and etching processes as described herein. For example, using the passivation layer 20 as an etch stop layer, an etch signal may be used to specify a time to stop the etching process after the etch process removes a portion of the passivation layer 20.

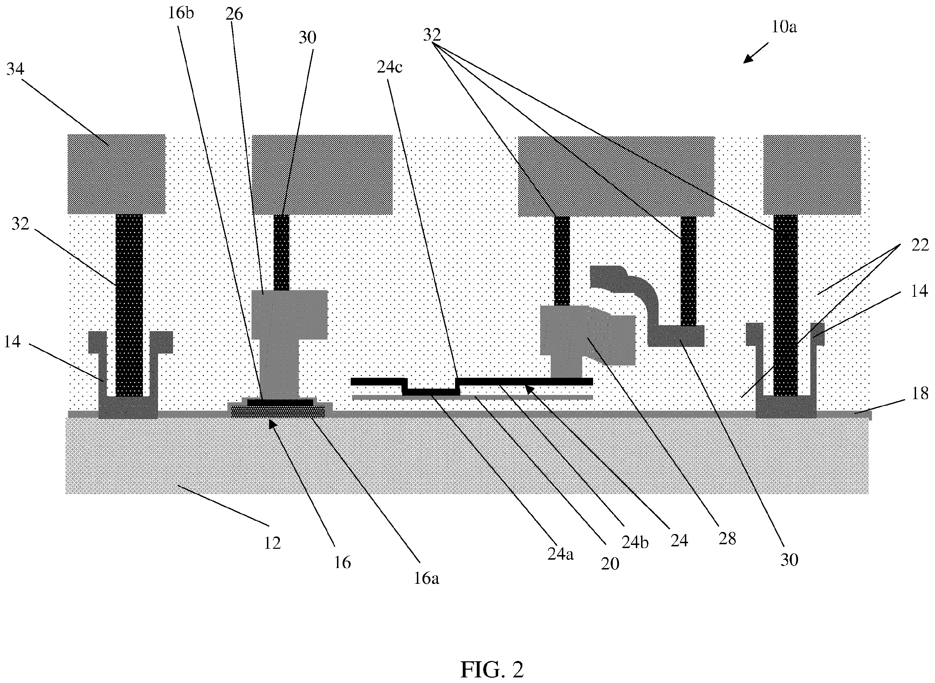

In more specific embodiments, a bottom portion 24a of the field plate 24 may be planar with the passivation layer 20, with remaining portions 24b of the field plate 24 being above the passivation layer 20. In alternative embodiments, the bottom portion 24a of the field plate 24 may be slightly recessed below the passivation layer 20 or on top of the passivation layer (see, e.g., FIG. 2), depending on the desired etching depth into the passivation layer 20. In any of the detailed configurations, the remaining portions 24b of the field plate 24 may be above and parallel with the passivation layer 20. In embodiments, the interlevel dielectric material 22 may be provided between the remaining portions 24b of the field plate 24 and the passivation layer 20.

It should be recognized by those of skill in the art that the bottom portion 24a of the field plate 24 has a uniform bottom surface and the field plate 24 includes 90 degree profiles 24c at a junction between the bottom portion 24a and the remaining portions 24b. More specifically, the 90 degree profiles 24c may be between a vertical leg 24d that extends between and connects to the bottom portion 24a and the remaining portions 24b. In embodiments, the junction of the 90 degree profile between the bottom portion 24a and the vertical leg 24d may be coincident (in contact) with the passivation layer 20. In further embodiments, interlevel dielectric material 22 may be provided between the remaining portions 24b of the field plate 24 and between the passivation layer 20 and the passivation layer 18. This configuration will improve off-state leakage, reduce or eliminate a leakage path, provide a higher dielectric field strength and reduce weak points (e.g., bread loafing) that may be present in conventional devices.

FIG. 1 further shows a gate contact metal 26 connecting to the gate structure 16 and, more specifically, the conductive material 16b formed over the doped GaN material 16a. An ohmic contact 30 contacts to the gate contact metal 26. A field contact metal (e.g., ohmic contact) 28 may also connect to the field plate 24. In embodiments, the gate contact metal 26, ohmic contact 30 and field contact metal 28 may be aluminum or copper formed by conventional deposition, patterning and etching processes as described herein.

Additional interlevel dielectric material 22 may be formed over the interlevel dielectric material 22. Back end of the line contacts (e.g., metal via contacts) 32 may connect to the ohmic contacts 14, 30, gate contact metal 26 and the field plate contact 28. Metal wiring 34 connects to the back end of the line contacts 32. The metal wiring 34 and the back end of the line contacts 32 may be formed by conventional lithography, etching and deposition methods as already described herein such that no further explanation is required for a complete understanding of the present disclosure.

FIG. 2 shows an alternative structure in accordance with aspects of the present disclosure. In the structure 10a of FIG. 2, the field plate 24 may be formed entirely above the passivation layer 20. More specifically, the bottom portion 24a of the field plate 24 may be in contact with a top surface of the passivation layer 20, with the remaining portions 24b of the field plate 24 above the passivation layer 20 as described with respect to FIG. 1. An intervening layer of interlevel dielectric material 22 remains between the remaining portions 24b of the field plate 24 and the passivation layer 20. In this way, the passivation layer 20 and the remaining portions 24b of the field plate 24 are isolated from one another and provide the advantages that are already described herein. The remaining features of the structure 10a of FIG. 2 are similar to the structure 10 of FIG. 1 such that no further explanation is required for a complete understanding of the present disclosure.

FIGS. 3A-3D show fabrication processes to manufacture the structure shown in FIG. 1. In FIG. 3A, the gate structure 16 may be formed on the semiconductor substrate 12. In embodiments, the gate structure comprises a p-doped GaN material 16a and conductive material 16b, e.g., titanium nitride, over the doped GaN material 16a. The p-doped GaN material 16a may be formed by an epitaxial growth process with an in-situ deposition, followed by a conventional patterning and etching process.

Examples of various epitaxial growth process apparatuses that can be employed in the present application include, e.g., rapid thermal chemical vapor deposition (RTCVD), low-energy plasma deposition (LEPD), ultra-high vacuum chemical vapor deposition (UHVCVD), atmospheric pressure chemical vapor deposition (APCVD) and molecular beam epitaxy (MBE). The epitaxial growth can be performed utilizing any well-known precursor gas or gas mixture. Carrier gases like hydrogen, nitrogen, helium and argon can be used. A p-type dopant may be added to the precursor gas or gas mixture.

The conductive material 16b, e.g., titanium nitride, may be formed by a conventional process. For example, the conductive material may be formed by a CVD process or a PVD puttering of TiN, in which a Ti sputter target is used and Ti is reacted to TiN in situ.

The passivation layer 18 may be formed over the gate structure 16 and semiconductor substrate 12. In embodiments, the passivation layer 18 may be, for example, by a blanket deposition of AlxOy (or other etch stop layers) over the semiconductor substrate 12, after formation of the gate structure 16. The passivation layer 18 may be deposited by, e.g., CVD or atomic layer deposition (ALD) processes. In this way, the passivation layer 18 covers the gate structure 16 and the exposed portions of the semiconductor substrate 12.

In FIG. 3B, an interlevel dielectric material 22 may be formed over the passivation layer 18. In embodiments, the interlevel dielectric material 22 may be formed by a conventional deposition process, e.g., CVD, optionally followed by a planarization process. The interlevel dielectric material 22 may be an oxide material or a nitride material or combinations thereof. Preferably, the interlevel dielectric material 22 is selective to a passivation layer 20.

The passivation layer 20 may be formed over the interlevel dielectric material 22. In this way, the passivation layer 20 may be separated from the passivation layer 18 by the interlevel dielectric material 22. As shown in FIG. 3B, the passivation layer 20 may be planar. The passivation layer 20 may be an etch stop layer, which comprises a material that is selective to the interlevel dielectric material 22. For example, the passivation layer 20 may be AlxOy. In preferred embodiments, the passivation layer 20 may be the same material as the passivation layer 18. The passivation layer 20 may be formed by a conventional blanket deposition process, e.g., CVD or ALD processes, followed by conventional lithography and etching processes as already described herein. In embodiments, the passivation layer 20 may be formed between the gate structure 16 and a drain region of the device.

In FIG. 3C, additional interlevel dielectric material 22 may be formed over the passivation layer 20. A trench 100 may be formed in the interlevel dielectric material 22 to expose the underlying passivation layer 20. In embodiments, the trench 100 may extend through the underlying passivation layer 20 as shown in FIG. 1, or above the passivation layer 22 (which exposes the passivation layer 22) as shown in FIG. 2. The trench 100 may be formed by conventional lithography and etching processes as described herein such that no further explanation is required for a complete understanding of the present disclosure.

The field plate 16 may be formed in the trench 100 and on a surface of the interlevel dielectric material 22. In embodiments, the field plate 16 may be formed by depositing conductive material in direct contact with a portion of the passivation layer 20 (e.g., edges of the etched passivation layer 20 as shown in FIG. 1 or a top surface of the passivation layer 20 as shown in FIG. 2).

The conductive material may be tantalum nitride deposited by a conventional deposition process, e.g., CVD or PVD/sputtering, and patterned using conventional lithography and etching processes as described herein. The bottom portion 24a of the field plate 24 may be planar with the passivation layer 20 as shown in FIG. 1 or above the passivation layer 20 as shown in FIG. 2. The different configurations may be due to the etching depth into the passivation layer 20 and/or interlevel dielectric material 22. In either configuration, the remaining portions 24b of the field plate 24 may be above the passivation layer 20, coplanar with and separated from passivation layer 20 by the interlevel dielectric material 22. In this way, the interlevel dielectric material 22 may be uniform between the passivation layer 20 and the field plate 24.

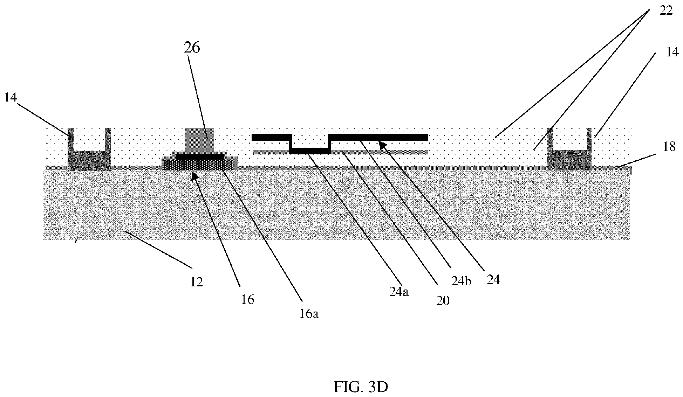

FIG. 3D shows the formation of the ohmic contacts 14 and the gate contact metal 26 connecting to the conductive material 16b of the gate structure 16. In embodiments, the ohmic contacts 14 and the gate contact metal 26 may be formed in the same or different lithography, etching and deposition steps as is known in the art such that no further explanation is required for a complete understanding of the present disclosure. As further shown in FIG. 1, for example, the ohmic contacts 28, 30, back end of the line contacts 32 and wiring structures 34 may be formed by conventional lithography, patterning and etching processes as described herein and as is known in the art such that no further explanation is required for a complete understanding of the present disclosure.

The structures can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multichip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

In summary, the present disclosure relates to semiconductor structures and, more particularly, to high-electron-mobility transistors with field plates and methods of manufacture. The structure includes: a gate structure on a semiconductor substrate; a passivation layer adjacent to the gate structure and above the semiconductor substrate; an insulator material over the passivation layer; and a field plate comprising a first portion contacting the passivation layer and a second portion being separated from the passivation layer by the insulator material.

The following embodiments are explicitly disclosed.

### Embodiment 1:

A structure comprising:
a gate structure;
a passivation layer adjacent to the gate structure;
an insulator material over the passivation layer; and
a field plate comprising a first portion contacting the passivation layer and a second portion being separated from the passivation layer by the insulator material.

In some illustrative examples herein, the gate structure may be on a semiconductor substrate and the passivation layer may be adjacent to the gate structure and above the semiconductor substrate.

### Embodiment 2:

The structure of embodiment 1, wherein the first portion of the field plate is planar with the passivation layer and the second portion of the field plate is parallel to the passivation layer.

### Embodiment 3:

The structure of embodiment 2, wherein edges of the first portion of the field plate are coincident with the passivation layer.

### Embodiment 4:

The structure of one of embodiments 1 to 3, wherein a junction of the first portion and the second portion of the field plate comprises 90 degree profiles, and a dielectric material is between the second portion of the field plate and the passivation layer.

### Embodiment 5:

The structure of one of embodiments 1 to 4, wherein the passivation layer is planar.

### Embodiment 6:

The structure of one of embodiments 1 to 5, wherein the passivation layer comprises AlxOy.

### Embodiment 7:

The structure of one of embodiments 1 to 6, wherein the first portion of the field plate is above and in contact with the passivation layer.

### Embodiment 8:

The structure of embodiment 7, wherein the second portion of the field plate is parallel to the passivation layer with interlevel dielectric material separating the second portion of the field plate and the passivation layer.

### Embodiment 9:

The structure of one of embodiments 1 to 8, wherein the semiconductor substrate is a stack of AlGaN material and the gate structure comprises pGaN material.

### Embodiment 10:

The structure of one of embodiments 1 to 9, wherein the field plate is located between the gate structure and a drain region adjacent to the gate structure.

### Embodiment 11:

A structure comprising:
a gate structure;
a source region comprising a first ohmic contact adjacent to a first side of the gate structure;
a drain region comprising a second ohmic contact adjacent to a second side of the gate structure;
a passivation layer between the gate structure and the drain region;
a field plate comprises a first portion contacting a first portion of the passivation layer and a second portion separated from a second portion the passivation layer; and
an insulator material between the second portion of the field plate and the second portion of the passivation layer.

In some illustrative examples of embodiment 11, the structure of embodiment 11 may be related to one of embodiments 1 to 10, further comprising:
a source region comprising a first ohmic contact adjacent to a first side of the gate structure; and
a drain region comprising a second ohmic contact adjacent to a second side of the gate structure,
wherein the passivation layer is between the gate structure and the drain region,
wherein the field plate comprises the first portion contacting a first portion of the passivation layer and the second portion separated from a second portion the passivation layer, and
wherein the structure further comprises an insulator material between the second portion of the field plate and the second portion of the passivation layer.

### Embodiment 12:

The structure of embodiment 11, wherein the first portion of the field plate is planar with the first portion of the passivation layer and the second portion of the field plate is above and parallel with the second portion of the passivation layer.

### Embodiment 13:

The structure of embodiment 11 or 12, wherein the passivation layer comprises AlxOy, the field plate comprises a metal material and the insulator material comprises silicon dioxide.

### Embodiment 14:

The structure of one of embodiments 11 to 13, further comprising a second passivation layer over the gate structure and under the first passivation layer.

### Embodiment 15:

The structure of embodiment 14, wherein the first passivation layer and the second passivation layer are separated by the insulator material.

### Embodiment 16:

The structure of embodiment 14 or 15, wherein the second passivation layer comprises AlxOy.

### Embodiment 17:

The structure of one of embodiments 11 to 16, wherein the first portion of the field plate sits on the first portion of the passivation layer and the second portion of the field plate is above the second portion of the passivation layer.

### Embodiment 18:

The structure of one of embodiments 11 to 17, wherein the gate structure comprises a GaN high-electron-mobility transistor.

### Embodiment 19:

The structure of one of embodiments 11 to 18, wherein edges of the first portion of the field plate comprise a 90 degree profile which are coincident.

### Embodiment 20:

A method comprising:
forming a gate structure on a semiconductor substrate;
forming a passivation layer adjacent to the gate structure and above the semiconductor substrate;
forming an insulator material over the passivation layer; and
forming a field plate comprising a first portion contacting the passivation layer and a second portion being separated from the passivation layer by the insulator material.

### Embodiment 21:

The method of embodiment 20, wherein the structure of one of embodiments 1 to 19 is formed.

In summary of the above, the present disclosure relates to semiconductor structures and, more particularly, to high-electron-mobility transistors with field plates and methods of manufacture. The structure includes: a gate structure on a semiconductor substrate; a passivation layer adjacent to the gate structure and above the semiconductor substrate; an insulator material over the passivation layer; and a field plate comprising a first portion contacting the passivation layer and a second portion being separated from the passivation layer by the insulator material.

## Claims

1. A structure, comprising:
a gate structure, preferably on a semiconductor substrate;
a passivation layer adjacent to the gate structure, the passivation layer preferably being above the semiconductor substrate;
an insulator material over the passivation layer; and
a field plate comprising a first portion contacting the passivation layer and a second portion being separated from the passivation layer by the insulator material.

2. The structure of claim 1, wherein the first portion of the field plate is planar with the passivation layer and the second portion of the field plate is parallel to the passivation layer.

3. The structure of claim 2, wherein edges of the first portion of the field plate are coincident with the passivation layer.
wherein a junction of the first portion and the second portion of the field plate preferably comprises 90 degree profiles, a dielectric material preferably being between the second portion of the field plate and the passivation layer.

4. The structure of one of claims 1 to 3, wherein the passivation layer is planar and/or comprises AlxOy.

5. The structure of one of claims 1 to 4, wherein the first portion of the field plate is above and in contact with the passivation layer, the second portion of the field plate preferably being parallel to the passivation layer with interlevel dielectric material separating the second portion of the field plate and the passivation layer.

6. The structure of one of claims 1 to 5, wherein the semiconductor substrate is a stack of AlGaN material and the gate structure comprises pGaN material.

7. The structure of one of claims 1 to 6, wherein the field plate is located between the gate structure and a drain region adjacent to the gate structure.

8. The structure of one of claims 1 to 7, further comprising:
a source region comprising a first ohmic contact adjacent to a first side of the gate structure; and
a drain region comprising a second ohmic contact adjacent to a second side of the gate structure,
wherein the passivation layer is between the gate structure and the drain region,
wherein the field plate comprises the first portion contacting a first portion of the passivation layer and the second portion separated from a second portion the passivation layer, and
wherein the structure further comprises an insulator material between the second portion of the field plate and the second portion of the passivation layer.

9. The structure of claim 8, wherein the first portion of the field plate is planar with the first portion of the passivation layer and the second portion of the field plate is above and parallel with the second portion of the passivation layer, and/or
wherein the first portion of the field plate sits on the first portion of the passivation layer and the second portion of the field plate is above the second portion of the passivation layer.

10. The structure of claim 9, wherein the passivation layer comprises AlxOy, the field plate comprises a metal material and the insulator material comprises silicon dioxide.

11. The structure of claim 10, further comprising a second passivation layer over the gate structure and under the first passivation layer, the second passivation layer preferably comprising AlxOy.

12. The structure of claim 11, wherein the first passivation layer and the second passivation layer are separated by the insulator material.

13. The structure of one of claims 8 to 12, wherein the gate structure comprises a GaN high-electron-mobility transistor.

14. The structure of one of claims 8 to 14, wherein edges of the first portion of the field plate comprise a 90 degree profile which are coincident.

15. A method, comprising:
forming a gate structure on a semiconductor substrate;
forming a passivation layer adjacent to the gate structure and above the semiconductor substrate;
forming an insulator material over the passivation layer; and
forming a field plate comprising a first portion contacting the passivation layer and a second portion being separated from the passivation layer by the insulator material.
